(19) Europäisches Patentamt
European Patent Office
Office européen des brevets

(11) **EP 3 740 836 B1**

(12) **EUROPÄISCHE PATENTSCHRIFT**

(45) Veröffentlichungstag und Bekanntmachung des Hinweises auf die Patenterteilung:
**13.03.2024 Patentblatt 2024/11**

(21) Anmeldenummer: **18808316.6**

(22) Anmeldetag: **23.11.2018**

(51) Internationale Patentklassifikation (IPC):
**G05F 1/563** *(2006.01)* **G05F 1/569** *(2006.01)*
**G05F 1/571** *(2006.01)*

(52) Gemeinsame Patentklassifikation (CPC):
**G05F 1/563; G05F 1/569; G05F 1/571; G05F 1/575; G05F 1/595**

(86) Internationale Anmeldenummer:
**PCT/EP2018/082313**

(87) Internationale Veröffentlichungsnummer:
**WO 2019/141416 (25.07.2019 Gazette 2019/30)**

(54) **SCHALTUNG ZUM ERKENNEN VON SCHALTUNGSDEFEKTEN UND ZUR VERMEIDUNG VON ÜBERSPANNUNGEN IN REGLERN**

CIRCUIT FOR DETECTING CIRCUIT DEFECTS AND FOR PREVENTING OVERVOLTAGES IN CONTROLLERS

CIRCUIT POUR LA DÉTECTION DE DÉFAUTS DE CIRCUIT ET POUR LA PRÉVENTION DE SURTENSIONS DANS DES RÉGULATEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.01.2018 DE 102018200668**

(43) Veröffentlichungstag der Anmeldung:
**25.11.2020 Patentblatt 2020/48**

(73) Patentinhaber: **Robert Bosch GmbH
70442 Stuttgart (DE)**

(72) Erfinder: **BALASUBRAMANIAM, Harish
70435 Stuttgart (DE)**

(56) Entgegenhaltungen:
CN-B- 102 393 779    US-A1- 2009 033 298
US-A1- 2010 201 331    US-A1- 2012 086 419

EP 3 740 836 B1

**Beschreibung**

Die vorliegende Erfindung betrifft eine elektrische Schaltung zum Erkennen von Schaltungsdefekten und/oder zur Vermeidung von Überspannungen in Reglern, umfassend eine Leistungsreglerschaltung und eine Überspannungsunterdrückungsschaltung, wobei die Leistungsreglerschaltung zur Bereitstellung einer Spannung für die Überspannungsunterdrückungsschaltung und die Überspannungsunterdrückungsschaltung zur Bereitstellung einer geschützten Spannung vorgesehen ist.

Stand der Technik

Aus dem Stand der Technik sind verschiedene Verfahren bekannt, mit denen eine Überspannung in einer elektrischen Schaltung erkannt werden kann.

Die US-Patentschrift US 7,576,964 B2 offenbart beispielsweise eine Überspannungsschutzschaltung für einen Schaltkreis eines MOS-Transistors und eines Verbrauchers, der zwischen einer ersten Stromversorgung und einer zweiten Stromversorgung in Reihe geschaltet ist. Die Überspannungsschutzschaltung enthält eine Steuersignalschaltung, eine dynamische Klemmschaltung, einen Steuerschalter und eine Überspannungserfassungsschaltung.

Ferner ist aus der US-Patentschrift US 9,007,737 B2 eine Überspannungsschutzschaltung umfassend einen Widerstandsteiler, eine Referenzspannungsversorgungseinheit, einen Komparator und einen Wechselrichter bekannt, wobei der Wechselrichter aus einer seriell-parallelen Kombinationsschaltung von ersten bis dritten Halbleiterschaltelementen besteht, welche von der Ausgabe des Komparators angesteuert werden. Dabei werden das erste Halbleiterschaltelement und das zweite Halbleiterschaltelement oder das dritte Halbleiterschaltelement durch Empfangen des Ausgangssignals des Komparators angesteuert und geben eine externe Spannung aus, wenn die externe Spannung innerhalb des Bereichs der für einen internen Schaltkreis erforderlichen Spannung liegt. Auf diese Weise fließt die externe Spannung auf Masse und bringt damit die an der internen Schaltung anliegende Spannung auf 0 Volt, um den internen Schaltkreis vor einer externen Überspannung zu schützen.

Zudem beschreibt die Veröffentlichung "Low drop regulator with overvoltage protection and reset function for automotive environment" des Institute of Electrical and Electronics Engineers (IEEE) wie ein bipolarer Hochspannungsprozess Integration eines Spannungsreglers ermöglicht, der mit einem minimalen Spannungsabfall arbeiten und positiven sowie negativen Überspannungen bis zu 80 Volt standhalten kann. Ein leistungsseitiger voll Oberflächen-geschützter PNP-Transistor ermöglicht diesen großen Einsatzbereich, der insbesondere von Automobil- und Industrieanwendungen benötigt wird. Eine sogenannte "Zener-Zap-Trimm"-Referenz ermöglicht eine präzise Ein- und Ausschaltung der Reset-Logik ohne einstellbare oder hochpräzise externe Komponenten.

In den vorgenannten Verfahren werden Überspannungsereignisse vermieden oder detektiert, indem die Zerstörung des Ausgangs-MOS-Transistors unter Verwendung einer Überspannungserfassungs- und Klemmschaltung verhindert wird, wodurch der Ausgangs-MOS-Transistor abgeschaltet wird und die Ausgangsspannung auf Masse gezogen wird oder ein Abschalten des Ausgangs-Leistungs-PNP-Transistors erfolgt.

Bei jedem der Verfahren wird angenommen, dass der Ausgangs-MOS/PNP-Transistor keinen Defekt wie einen Kurzschluss zwischen Drain und Source oder zwischen Kollektor und Emitter aufweist. Ein solcher Defekt kann dazu führen, dass eine externe Batteriespannung direkt an der Last beziehungsweise am Verbraucher ohne jegliche Regelung auftritt, die zur Zerstörung der Onchip-Schaltungen und der Last beziehungsweise des Verbrauchers führt. Dies ist im Bereich Automotive wichtig, da die Batteriespannungen nominell bei 14 Volt liegen und im Fall einer Lastablagerung steigen können.

Die US 2009/0033298 A1 offenbart eine Schaltung zur Regelung einer Spannung mit minimaler Leistung und schnellem Einschwingverhalten.

Die US 2012/0086419 A1 offenbart ein Stromversorgungsgerät, einen Verarbeitungschip für ein digitales Mikrofon und ein dazugehöriges digitales Mikrofon, wodurch ein Stromversorgungsgerät mit einem höheren Versorgungsspannungsdurchgriff bereitgestellt wird.

Offenbarung der Erfindung

Erfindungsgemäß wird eine elektrische Schaltung zum Erkennen von Schaltungsdefekten und/oder zur Vermeidung von Überspannungen in Reglern gemäß Patentanspruch 1 zur Verfügung gestellt.

Vorteile der Erfindung

Die vorliegende Erfindung ermöglicht nicht nur die Erfassung von Defekten in den verschiedenen Teilschaltungen eines Reglers, sondern auch im Ausgangs-MOS-Transistor selbst. Jeder Defekt in den Teilschaltungen und dem Ausgangs-MOS-Transistor kann ein Überspannungs- oder Unterspannungsereignis verursachen, das eine Fehlfunktion oder die Zerstörung des Chips verursacht.

Zudem ermöglicht die vorliegende Erfindung nicht nur die Erfassung von Überspannungsereignissen, sondern begrenzt diese auch, sodass im Bereich von 2,7 Volt bis 3,6 Volt arbeitende Digitallogik und Lastkreise ordnungsgemäß funktionieren können. Dies ermöglicht der digitalen Logik die Ergreifung von entsprechenden Maßnahmen, wie beispielsweise die Maßnahme einer gesteuerten Abschaltung. Die Spannungsunterdrückungsschaltung begrenzt die Spannung auf den maximalen Betriebsbereich der versorgten Schaltungen, sodass sie auch bei Vorhandensein eines Defekts, wie zum Beispiel eines Drain-Source-Kurzschlusses des Leistungstransistors, einwandfrei funktionieren. Dies ist besonders nützlich für die Anwendung im Bereich Automotive, in welchem eine unkontrollierte Abschaltung zu unerwünschtem Verhalten führen kann.

Die vorliegende Erfindung umfasst die elektrische Schaltung ferner einen dritten Transistor, dessen Gate-Anschluss mit dem Source-Anschluss des zweiten Transistors der Überspannungsunterdrückungsschaltung verbunden ist und welcher zur Begrenzung einer Überspannung am Source-Anschluss des dritten Transistors vorgesehen ist. Dadurch kann erfindungsgemäß erreicht werden, dass ein Spannungswert über 3,6 Volt am Drain-Anschluss des dritten Transistors nicht am Source-Anschluss zulässig wird.

Gemäß der Ausgestaltung der elektrischen Schaltung ist am Source-Anschluss des dritten Transistors ein Eingang eines Komparators angeschlossen, welcher zur Detektion einer Überspannung durch Vergleich der begrenzten Spannung mit einer Spannung der zweiten Referenzspannungsquelle vorgesehen ist. Auf diese Weise ist ein weiterverarbeitbares binäres Ausgangssignal erzeugbar, welches das Vorliegen einer Überspannung indiziert.

Bevorzugter Weise ist der zur Detektion einer Überspannung vorgesehene erste Komparator zur Ausgabe eines eine Überspannung darstellenden binären Wertes vorgesehen. Dies ermöglicht, dass trotz Nutzung der gleichen zweiten Referenzspannungsquelle durch einen zweiten Komparator und den Schutzregler Defekte in der zweiten Referenzspannungsquelle, welche zu einem niedrigeren Zielwert führen, vom ersten Komparator erkannt werden können.

In einer vorteilhaften Ausgestaltung umfasst die elektrische Schaltung ferner eine Schaltung zur Detektion einer Unterspannung des Leistungsreglers mit einem die Spannung der zweiten Referenzspannungsquelle mit einer über die bereitgestellte geschützte Spannung erhaltenen Spannung vergleichenden zweiten Komparator. Dadurch kann ein weiterverarbeitbares binäres Ausgangssignal erzeugt werden, welches das Vorliegen einer Unterspannung indiziert.

In einer besonderen Ausführungsform der Erfindung ist dabei der zur Detektion einer Unterspannung vorgesehene Komparator zur Ausgabe eines eine Unterspannung darstellenden binären Wertes vorgesehen. Dadurch kann erreicht werden, dass ein vordefinierter Spannungswert nicht unterschritten wird, sodass im Bereich von 2,7 Volt bis 3,6 Volt arbeitende Digitallogik und Lastkreise ordnungsgemäß funktionieren können.

Gemäß einer alternativen Ausführungsform der Erfindung umfasst die elektrische Schaltung ferner eine Schaltung zur Detektion einer Unterspannung des Leistungsreglers mit zwei Komparatoren, wobei ein Vergleich der über die Spannung der ersten beziehungsweise zweiten Referenzspannungsquelle erhaltenen Spannung mit einer von mittels der bereitgestellten geschützten Spannung erhaltenen Spannung vorgesehen ist. Dadurch wird eine deutliche Unterscheidung zwischen einer Überspannung bei der von der Leistungsreglerschaltung bereitgestellten Spannung und einer Unterspannung bei der bereitgestellten geschützten Spannung ermöglicht

Vorteilhafterweise sind die zwei Komparatoren dabei zur Ausgabe eines eine Unterspannung darstellenden binären Wertes vorgesehen. Gemäß einer bevorzugten Ausführungsform der Erfindung ist ferner ein logisches Und-Gatter zur Verknüpfung der die eine Unterspannung reflektierenden binäre Werte vorgesehen. Dadurch wird im Fall einer von der Leistungsreglerschaltung bereitgestellten Spannung, welche einen vordefinierten Wert deutlich unterschreitet, ein Ausgabewert zusätzlich auf 1 gesetzt, sodass ein Fehler in der zweiten Referenzspannungsquelle erkannt werden kann.

Gemäß einer weiteren alternativen Ausführungsform der Erfindung umfasst die elektrische Schaltung ferner einen Unterspannungserkennungs-Komparator mit wechselbarer Referenzquelle zur Detektion eines Defekts in den Referenzquellen, welcher zu einer Überspannung des Leistungsreglers oder zu einer Unterspannung des Schutzreglers führt. Dadurch wird eine deutliche Unterscheidung zwischen einer Überspannung beziehungsweise Unterspannung aufgrund von Fehlern in den Reglern und Fehlern in den Referenzen ermöglicht.

Bevorzugter Weise umfasst die erfindungsgemäße elektrische Schaltung einen Digitalteil, an welchen eine Bereitstellung der geschützten Spannung vorgesehen ist. Durch einen derartigen Digitalteil können insbesondere bestimmte Bauteile der elektrischen Schaltung wie Leistungsregler und/oder Komparatoren elektrisch stimuliert werden.

Gemäß einer weiteren vorteilhaften Variante der Erfindung weist der Digitalteil Eingänge zum Empfang binärer Werte und Ausgänge zum Senden binärer Werte auf. Durch das Senden binärer Werte kann beispielsweise ein kontrolliertes Abschalten von Lastkreisen auf Basis empfangener binärer Werte eingeleitet werden, um Schäden an der elektrischen Schaltung und/oder an deren Verbrauchern beziehungsweise Lastkreisen zu vermeiden.

Erfindungsgemäß kann ferner vorgesehen sein, dass eine Versorgung der ersten Referenzspannungsquelle, der zweiten Referenzspannungsquelle, der Leistungsreglerschaltung und der Überspannungsunterdrückungsschaltung mittels einer externen Batteriespannung vorgesehen ist.

Vorteilhafte Weiterbildungen der Erfindung sind in den Unteransprüchen angegeben und in der Beschreibung beschrieben.

Zeichnungen

Ausführungsbeispiele der Erfindung werden anhand der Zeichnungen und der nachfolgenden Beschreibung näher erläutert. Es zeigen:

Figur 1 eine erfindungsgemäße Schaltung zur Detektion von Defekten und zur Überspannungsunterdrückung,

Figur 2 in einem Ablaufdiagramm die entsprechend der erfindungsgemäßen Schaltung realisierten Werteänderungen während einer BIST-Phase,

Figur 3 eine weitere Ausführungsform der erfindungsgemäßen Schaltung, welche eine deutliche Unterscheidung zwischen einer Überspannung bei $V_{DD\_PWR}$ und einer Unterspannung bei $V_{DD\_PROT}$ aufgrund eines Defekts in den Referenzen ermöglicht,

Figur 4 eine Ausführungsform der erfindungsgemäßen Schaltung, welche im Vergleich zu dem aus Figur 3 bekannten Ausführungsbeispiel nur einen Unterspannungskomparator benötigt, und

Figur 5 eine alternative, einen Abschaltmodus/Standbymodus ermöglichende Ausführungsform der erfindungsgemäßen Schaltung.

Ausführungsformen der Erfindung

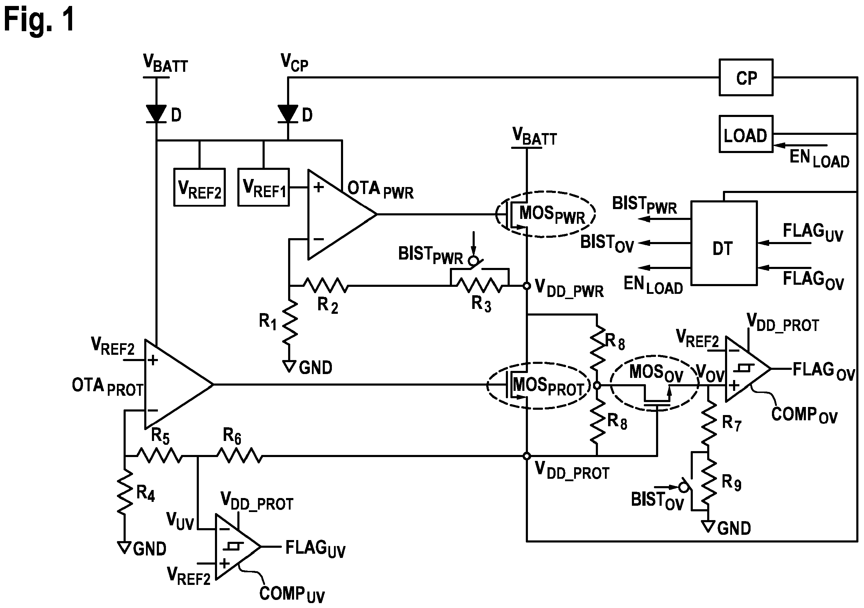

In Figur 1 ist eine erfindungsgemäße Schaltung zur Detektion von Defekten und zur Überspannungsunterdrückung für ein Hochspannungs-BCD (Bipolar, CMOS und DMOS)-Halbleiterverfahren dargestellt, welche für Anwendungen im Bereich Automotive geeignet ist. Eine Anpassung der Schaltung an andere Halbleiterprozesse ist ebenfalls möglich.

Der Regler wird von einer Batterie mit der Spannung $V_{BATT}$ versorgt. Der Leistungsregler beinhaltet den Hochspannungs-Transistor $MOS_{PWR}$, eine den Operationsverstärker $OTA_{PWR}$ und die Unterspannungs-Bandabstandsreferenz $V_{REF1}$ als Referenzspannungsquelle umfassende Regelschleife und die hochohmigen Rückkopplungswiderstände $R_1$, $R_2$ sowie $R_3$. Der Leistungsregler liefert die Spannung $V_{DD\_PWR}$ für die Überspannungsunterdrückungsschaltung.

Die Überspannungsunterdrückungsschaltung beinhaltet den Hochspannungs-Schutztransistor $MOS_{PROT}$, die den Operationsverstärker $OTA_{PROT}$ und die Unterspannungs-Bandabstandsreferenz $V_{REF2}$ als Referenzspannungsquelle umfassende Regelschleife und hochohmige Rückkopplungswiderstände $R_4$, $R_5$ sowie $R_6$. Die Überspannungsunterdrückungsschaltung liefert die geschützte Spannung $V_{DD\_PROT}$ an die durch das Digitalteil DT dargestellte digitale Logik und die Lastkreise LOAD, CP.

Die von der Spannung $V_{DD\_PROT}$ versorgte Ladungspumpe CP liefert für die Operationsverstärker $OTA_{PWR}$ und $OTA_{PROT}$ eine höhere Spannung $V_{CP}$ bei eine niedrigere $V_{BATT}$ Spannung, sodass die Spannung an Drain- und Source-Anschluss der Transistoren $MOS_{PWR}$ und $MOS_{PROT}$ nur durch ihre Einschaltwiderstände und Lastströme und nicht durch ihre Regelspannung am Gate begrenzt ist.

Zur besseren Verständlichkeit der erfindungsgemäßen Schaltung sind folgende Zusammenhänge gegeben:

$$(1) \qquad R_2 = R_1 * 2085 / 1215$$

$$(2) \qquad R_3 = R_1 * 300 / 1215$$

$$(3) \qquad R_5 = R_4 * 288 / 1215$$

$$(4) \qquad R_6 = R_4 * 1897 / 1215$$

$$(5) \qquad R_8 = R_7 * 4670 / 1215$$

$$(6) \qquad R_9 = R_7 * 55 / 1215$$

$$(7) \qquad V_{DD\_PWR} = V_{REF1} * (3300 + (BIST_{PWR} * 300)) / 1215$$

$$(8a) \qquad V_{DD\_PROT} = V_{DD\_PWR} \qquad\qquad \text{für } V_{DD\_PWR} < 3{,}4 \text{ V}$$

$$(8b) \qquad V_{DD\_PROT} = V_{REF2} * 3400 / 1215 \qquad\qquad \text{für } V_{DD\_PWR} \geq 3{,}4 \text{ V}$$

$$(9) \qquad V_{UV} = V_{DD\_PROT} * 1503 / 3400$$

$$(10) \qquad V_{OV} = (V_{DD\_PWR} + V_{DD\_PROT}) / (2 + (4670 / (1215 + (BIST_{OV} * 55))))$$

$$(11a) \qquad FLAG_{UV} = 1 \qquad\qquad \text{für } V_{UV} < V_{REF2}$$

$$(11b) \qquad FLAG_{UV} = 0 \qquad\qquad \text{für } V_{UV} \geq V_{REF2}$$

$$(12a) \qquad FLAG_{OV} = 0 \qquad\qquad \text{für } V_{OV} < V_{REF2}$$

$$(12b) \qquad FLAG_{OV} = 1 \qquad\qquad \text{für } V_{OV} \geq V_{REF2}$$

Für den Parameter $V_{BATT}$ wird vorliegend ein Nennwert von 14 Volt, für den die Ausgangsspannung der Ladungspumpe darstellenden Parameter $V_{CP}$ ein Nennwert von > 7 Volt, für die Unterspannungs-Bandabstandsreferenzen $V_{REF1}$ und $V_{REF2}$ als Referenzspannungen jeweils ein Nennwert von 1,215 Volt, für die geregelte Spannung $V_{DD\_PWR}$ ein Nennwert von 3,3 Volt, für die geregelte Spannung $V_{DD\_PWR}$ unter $BIST_{PWR}$ ein Nennwert von 3,6 Volt sowie für die geregelte Spannung $V_{DD\_PROT}$ ein Nennwert von 3,4 Volt vorausgesetzt. Ferner muss der Nennwert von $V_{DD\_PROT}$ zur Aktivierung von $FLAG_{UV}$ kleiner als 2,75 Volt sein. Zur Aktivierung von $FLAG_{OV}$ muss der Durchschnitt von $((V_{DD\_PWR} + V_{DD\_PROT})/2)$ größer als 3,55 Volt liegen, wobei hingegen zur Aktivierung von $FLAG_{OV}$ in $BIST_{OV}$ der Durchschnitt von $((V_{DD\_PWR} + V_{DD\_PROT})/2)$ größer als 3,45 Volt liegen muss. Der Bereich der Betriebsspannung für die digitale Logik DT und die Lastkreise liegt im Bereich von 2,7 Volt bis 3,6 Volt.

Vorliegend wird eine Unterspannung des Reglers vom Komparator $COMP_{UV}$ und der Referenz $V_{REF2}$ erkannt, indem die $FLAG_{UV}$ auf den Wert 1 gesetzt wird, wenn die Spannung $V_{DD\_PROT}$ niedriger als ihre Schwelle von 2,75 Volt ist. Eine Überspannung des Reglers wird vom Komparator $COMP_{OV}$ und der Referenz $V_{REF2}$ erkannt, indem die $FLAG_{OV}$ auf den Wert 1 gesetzt wird, wenn die $V_{OV}$-Spannung größer als die $V_{REF2}$-Referenz ist. Der Transistor $MOS_{OV}$ begrenzt die maximale Spannung, die am positiven Eingang des Komparators $COMP_{OV}$ anliegt, wenn die Spannung $V_{DD\_PWR}$ höher als 3,6 Volt ist. Die digitale Logik und die Lastkreise funktionieren korrekt bei einer Versorgungsspannung zwischen 2,7 Volt und 3,6 Volt.

Im Normalbetrieb, wenn keine Defekte vorliegen, erlaubt der Schutzregler einen Durchlass der gesamten geregelten Spannung $V_{DD\_PWR}$ von 3,3 Volt. Dies liegt daran, dass der Schutzregler die Spannung $V_{DD\_PROT}$ auf einen höheren Wert von 3,4 Volt regelt. Daher wirkt im Normalbetrieb der Transistor $MOS_{PROT}$ als sogenannter Sourcefolger, was dazu führt, dass die Spannung $V_{DD\_PROT}$ gleich der Spannung $V_{DD\_PWR}$ von 3,3 Volt ist. Da die Spannung $V_{OV}$ kleiner als die $COMP_{OV}$-Schwelle von $V_{REF2}$ ist, wird $FLAG_{OV}$ im Normalbetrieb nicht auf den Wert 1 gesetzt.

Die vorliegende Erfindung bietet eine umfassende Abdeckung für Defekte innerhalb der Referenzen $V_{REF1}$ und $V_{REF2}$, den Regelpfaden für die Spannungen $V_{DD\_PWR}$ und $V_{DD\_PROT}$, den Ausgangstransistoren $MOS_{PWR}$ und $MOS_{PROT}$. Falls Defekte vorliegen, ändern sich die Werte von $V_{DD\_PWR}$, $V_{DD\_PROT}$, $V_{REF1}$ sowie $V_{REF2}$ und führen zur Aktivierung von $FLAG_{UV}$ oder $FLAG_{OV}$. Das Setzen von Werten für $FLAG_{UV}$ oder $FLAG_{OV}$ wird dann dazu verwendet, ein kontrolliertes Abschalten von Lastkreisen einzuleiten, um Schäden zu vermeiden.

Im Nachfolgenden werden die Mittel zum Erfassen von Defekten in jeder der Teilschaltungen anhand von Figur 1 näher beschrieben.

Ein Defekt der Spannungsquelle für die $V_{REF1}$-Referenzspannung kann dazu führen, dass der Wert der Spannung höher oder niedriger als der Nennwert von 1,215 Volt ist. Ist die $V_{REF1}$-Referenzspannung kleiner als der Sollwert 1,215 Volt, sodass die Spannungen $V_{DD\_PWR}$ und $V_{DD\_PROT}$ kleiner als 2,75 Volt sind, so wird FLAGuv durch den Komparator $COMP_{UV}$, der eine zweite unabhängige Referenzspannung $V_{REF2}$ verwendet, auf den Wert 1 gesetzt. Wenn die $V_{REF1}$-Referenzspannung höher als der Sollwert von 1,215 Volt ist, sodass die Spannung $V_{DD\_PWR}$ höher als 3,7 Volt ist und der Schutzregler den Ausgang $V_{DD\_PROT}$ auf 3,4 Volt regelt, wird $FLAG_{OV}$ auf den Wert 1 gesetzt, da der Durchschnitt von $((V_{DD\_PWR} + V_{DD\_PROT})/2)$ größer als 3,55 Volt ist und somit die Spannung Vov größer als der im Komparator COMPov eingestellte Schwellwert von $V_{REF2}$ ist.

Jeglicher Defekt des Regelpfades $V_{DD\_PWR}$ wie bei den Rückkopplungswiderständen $R_1$, $R_2$, $R_3$ oder dem Transistor $MOS_{PWR}$ bewirkt, dass die Spannung $V_{DD\_PWR}$ höher oder niedriger als der Nennwert von 3,3 Volt liegt. Wenn ein Defekt in der Regelschleife die Spannung $V_{DD\_PWR}$ abweichend vom Nennwert von 3,3 Volt niedriger als 2,75 Volt werden lässt, dann wird FLAGuv auf den Wert 1 gesetzt, um eine Unterspannung des Leistungsreglers anzuzeigen. Wenn ein Defekt in der Regelschleife, wie beispielsweise ein Drain-Source-Kurschluss des Transistor $MOS_{PWR}$, die Spannung $V_{DD\_PWR}$ von dem Wert 3,3 Volt nach oben abweichen lässt und diese größer als 3,7 Volt wird, erfolgt ein Setzen von FLAGov auf den Wert 1, um eine Überspannung im Leistungsregler anzuzeigen.

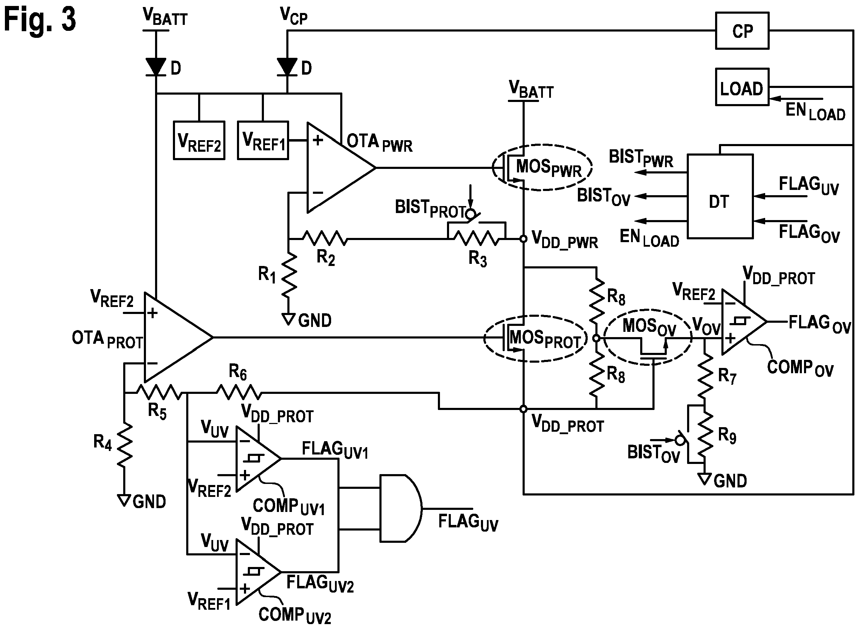

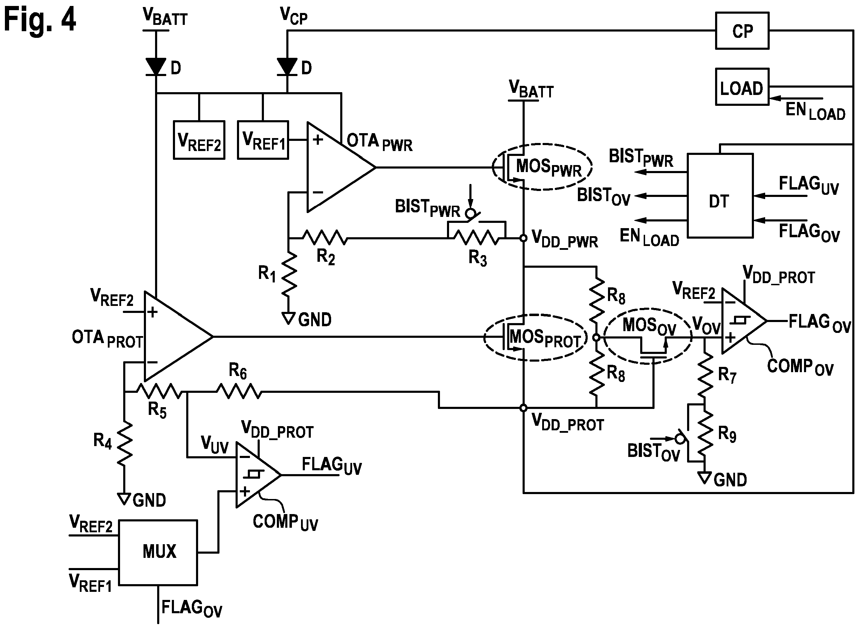

Ein Defekt der $V_{REF2}$-Referenz kann dazu führen, dass der Wert für $V_{REF2}$ höher oder niedriger als der Nennwert von 1,215 Volt ist. Ist der $V_{REF2}$-Wert kleiner als der Sollwert von 1,215 Volt, sodass der Schutzregler den Ausgang $V_{DD\_PROT}$ auf einen Wert kleiner als $V_{DD\_PWR}$ regelt, entwickelt sich eine Differenzspannung über dem Transistor $MOS_{PROT}$. Wenn der Unterschied groß genug ist, setzt der Komparator COMPov den Wert für FLAGov auf 1, um dadurch einen wahrscheinlichen Defekt in der $V_{REF2}$-Referenzspannung anzuzeigen. Basierend auf den vorgenannten Nennwerten und den Gleichungen (1) bis (12b) kann der Wert der $V_{REF2}$-Referenzspannung, bei der FLAGov auf den Wert 1 gesetzt ist, mit 1,084 Volt berechnet werden und der entsprechende Spannungsabfall der Spannung $V_{DD\_PROT}$ beträgt 3,033 Volt. Somit wird ein Defekt des $V_{REF2}$-Spannungswerts, der seinen Zielwert um mehr als 0,131 Volt verringert, durch Setzen des Wertes 1 für FLAGov angezeigt. Der Vorteil des vorgeschlagenen Überspannungsüberwachungskonzepts besteht darin, dass - obwohl der Komparator COMPuv und der Schutzregler die gleiche Referenz $V_{REF2}$ verwenden - durch den Wert von FLAGov Defekte in der $V_{REF2}$-Referenz, welche zu einem niedrigeren Zielwert führen, vom Komparator COMPov erkannt werden können. Die Einstellung des Wertes für FLAGov bedeutet in diesem Fall nicht zwangsläufig, dass eine Überspannung vorliegt, sondern deutet auf ein Problem in der $V_{REF2}$-Referenz hin, welches bewirkt, dass die Spannung $V_{DD\_PROT}$ niedriger als die Spannung $V_{DD\_PWR}$ ist. Wenn zwischen einer Überspannung bei $V_{DD\_PWR}$ und einer Unterspannung bei $V_{DD\_PROT}$ eine deutliche Unterscheidung getroffen werden muss, kann die später in Zusammenhang mit Figur 3 und Figur 4 beschriebene Ausführungsform verwendet werden. Ist der $V_{REF2}$-Wert höher als der Zielwert von 1,215 Volt, so versucht der Schutzregler, die Spannung $V_{DD\_PROT}$ auf einen höheren Wert zu regeln. Da aber der Eingang des Schutzreglers durch den Leistungsregler begrenzt ist, bleibt der Spannungswert für $V_{DD\_PROT}$ auf 3,3 Volt und damit der Wert der Spannung $V_{UV}$ unverändert. Der höhere Wert für die Spannung $V_{REF2}$ bewirkt jedoch, dass der Komparator COMPuv den Wert für FLAGuv auf 1 setzt, da der $V_{REF2}$-Wert höher als seine Schwellenspannung Vuv ist. Basierend auf den vorgenannten Nennwerten und den Gleichungen (1) bis (12b) kann die Zunahme von $V_{REF2}$, welche dazu führt, dass FLAGuv auf den Wert 1 gesetzt wird, mit 1,458 Volt berechnet werden. Somit wird ein Defekt der $V_{REF2}$, welche ihren Zielwert um 0,243 Volt erhöht, durch ein Setzen von FLAGuv auf den Wert 1 angezeigt. Die Einstellung des Wertes für FLAGuv bedeutet in diesem Fall nicht zwangsläufig, dass eine Unterspannung vorliegt, sondern deutet auf ein Problem in der $V_{REF2}$-Referenz hin, welches bewirkt, dass die Spannung Vuv niedriger als die Referenz $V_{REF2}$ ist.

Jeder Defekt des Regelpfades $V_{DD\_PROT}$, wie beispielsweise bei den Rückkopplungswiderständen $R_4$, $R_5$, $R_6$ oder beim Transistor $MOS_{PROT}$ bewirkt, dass die Spannung $V_{DD\_PROT}$ auf einen niedrigeren oder höheren Wert als den Nennwert von 3,4 Volt regelt. Wenn ein Defekt in der Regelschleife dazu führt, dass die Spannung $V_{DD\_PROT}$ nach unten vom Nennwert 3,4 Volt abweicht und niedriger als 2,75 Volt wird, wird FLAGuv auf den Wert 1 gesetzt, um einen Fehler im Regelpfad der Spannung $V_{DD\_PROT}$ anzuzeigen. Wenn ein Defekt in der Regelschleife, wie beispielsweise ein Drain-Source-Kurzschluss des Transistors $MOS_{PROT}$ dazu führt, dass die Spannung $V_{DD\_PROT}$ nach oben vom Nennwert 3,4 Volt abweicht und auf einen höheren Wert von 3,5 Volt oder mehr regelt, dann wird bei der BIST (Built-In Self-Test)-Phase das Verhalten des Wertes für FLAGov diesen Defekt anzeigen. Die BIST-Phase wird nach dem Einschalten des Reglers und vor der Aktivierung des Lastkreises durchgeführt. Falls ein Fehler besteht, wird die Aktivierung des Lastkreises und alle Schaltungen blockiert, bis der Fehler behoben ist. Während der BIST-Phase werden der die Spannung $V_{DD\_PWR}$ ausgebende Leistungsregler und der Komparator COMPov stimuliert, um ein bestimmtes Ausgangsmuster aus dem FLAGov zu erzeugen. Wenn sich dieses Muster ändert, zeigt es das Vorhandensein eines Defekts im Regelungspfad für $V_{DD\_PROT}$. Im Normalbetrieb, wenn keine Defekte vorliegen, stimuliert der Digitalteil DT den Leistungsregler durch das Signal $BIST_{PWR}$, sodass die Spannung $V_{DD\_PWR}$ auf 3,6 Volt ansteigt. Der Schutzregler regelt den Ausgang für die Spannung $V_{DD\_PROT}$ auf 3,4 Volt und die Spannung Vov, welche kleiner als der Referenzwert der Spannung $V_{REF2}$ ist, verhindert ein Setzen des Wertes 1 für FLAGov durch den Komparator COMPov. Als nächstes stimuliert der Digitalteil DT den Überspannungskomparator COMPov durch das ausgegebene Signal BISTov, sodass sich dessen Vergleichsschwelle ändert. Dadurch wird das FLAGov auf den Wert 1 gesetzt, da die Vov-Spannung nun höher als die Referenzspannung $V_{REF2}$ ist. Wenn also keine Defekte vorliegen, ist das erwartete Ausgangsmuster des FLAGov während der BIST-Phase ein Wert 0, gefolgt von einem Wert 1. Wenn jedoch der Regelpfad $V_{DD\_PROT}$ einen Defekt aufweist, sodass er mit 3,5 Volt auf einen höheren Wert als den Nennwert regelt, so wird während der BIST-Phase - wenn der Schutzregler vom Digitalteil DT durch das Signal $BIST_{PWR}$ stimuliert wird - der Wert für $V_{DD\_PROT}$ auf 3,5 Volt ansteigen und somit die Spannung Vov größer werden als die Referenzspannung $V_{REF2}$, wodurch der Komparator COMPov dazu veranlasst wird, FLAGov auf den Wert 1 zu setzen. Somit ist das Ausgangsmuster des FLAGov bei Vorhandensein eines Defekts in der Regelschleife der Wert 1, gefolgt von einem erneuten Wert 1. Ohne Defekt hingegen folgt auf einen ersten Wert 0 der zweite Wert 1. Tatsächlich wird in der BIST-Phase auch einen Fehler in der Regelschleife erkannt, wenn die Spannung $V_{DD\_PROT}$ nach unten vom Nennwert 3,4 Volt abweicht und auf einen kleineren Wert von 3,3 Volt oder weniger regelt. In diesem Fall ist das Ausgangsmuster von FLAGov bei Vorhandensein eines Defekts in der Regelschleife der Wert 0, gefolgt von einem erneuten Wert 0.

Das gleiche gilt für einen Defekt in den Transistoren $MOS_{PWR}$, $MOS_{PROT}$ oder in der Regelschleife bezüglich der Spannung $V_{DD\_PWR}$ oder der Referenzen $V_{REF1}$ und $V_{REF2}$. Tatsächlich wird die BIST-Phase nur bestanden, wenn der $V_{DD\_PWR}$-Regler und der $V_{DD\_PROT}$-Regler sowie die Referenzen $V_{REF1}$ und $V_{REF2}$ innerhalb ihrer Grenzen arbeiten. Basierend auf den vorgenannten Nennwerten und den Gleichungen (1) bis (12b), wird in der BIST-Phase ein Fehler produziert, wenn eine der Spannungen $V_{DD\_PWR}$ oder $V_{DD\_PROT}$ von ihrem Nennwert ca. $\pm 0,1$ Volt abweicht oder wenn eine der Referenzen $V_{REF1}$ oder $V_{REF2}$ von ihrem Nennwert ca. $\pm 0,034$ Volt abweicht. Wenn eine der Spannungen oder Referenzen nach oben abweicht, produziert der FLAGov in der BIST-Phase den Wert 1, gefolgt von einem erneuten Wert 1. Wenn die Spannung nach unten abweicht, produziert der FLAGov in der BIST-Phase den Wert 0, gefolgt von einem erneuten Wert 0.

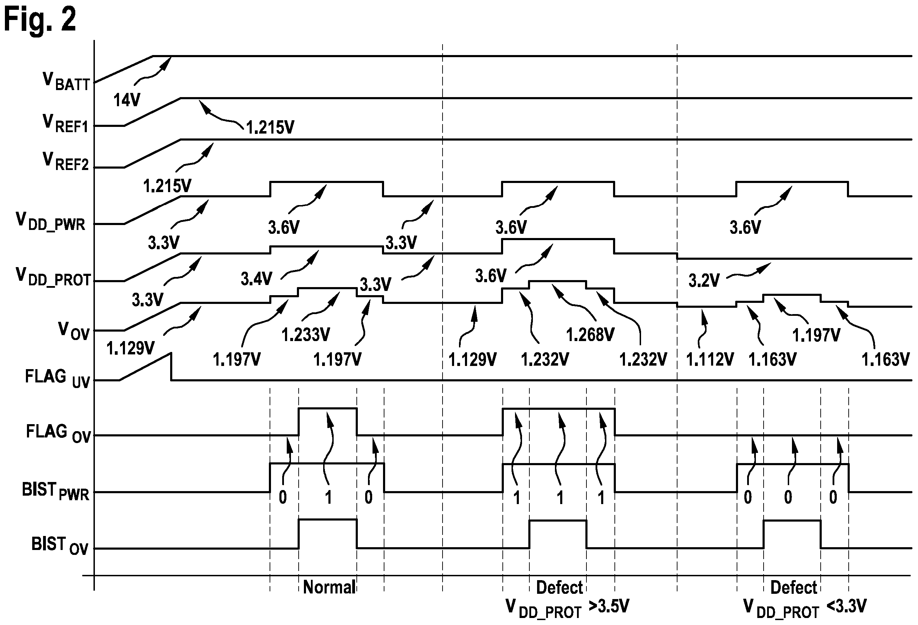

In Figur 2 sind die in Bezug auf Figur 1 erläuterten Abläufe für die erfindungsgemäße Schaltung anhand entsprechender Wellenformen während der BIST-Phase mit und ohne Defekt im Regelpfad grafisch dargestellt. Dabei sind für die Parameter $V_{BATT}$, $V_{REF1}$, $V_{REF2}$, $V_{DD\_PWR}$, $V_{DD\_PROT}$ und $V_{OV}$ die entsprechenden Spannungswerte in Volt angegeben, wobei hingegen für die Parameter FLAGuv, FLAGov, $BIST_{PWR}$ und BISTov die logischen beziehungsweise binären Werte 0 und 1 angenommen werden können. Wie vorstehend erläutert wurde, stellt die im Verlauf des Parameters FLAGov als erste dargestellte Abfolge der Werte 0 und 1 das Vorliegen einer defektfreien $V_{DD\_PROT}$-Regelschleife dar. Die anschließend dargestellte Abfolge der Werte 1 und 1 oder 0 und 0 für den Parameter FLAGov lässt hingegen das Vorliegen eines Defekts in der $V_{DD\_PROT}$-Regelschleife erkennen.

In Figur 3 ist eine Ausführungsform der erfindungsgemäßen Schaltung dargestellt, welche eine deutliche Unterscheidung zwischen einer Überspannung bei $V_{DD\_PWR}$ und einer Unterspannung bei $V_{DD\_PROT}$ ermöglicht. Dabei umfasst die Schaltung zusätzlich zwei Doppelspannungserkennungskomparatoren COMPuv, und $COMP_{UV2}$, welche auf den Referenzspannungen $V_{REF1}$ und $V_{REF2}$ arbeiten. Bei dieser Ausführungsform wird, wenn die Spannung $V_{DD\_PROT}$ deutlich niedriger als 2,75 Volt ist, der Wert für FLAGuv aufgrund des zwischengeschalteten logischen Und-Gatters AND durch den Komparator $COMP_{UV2}$, der auf der Referenzspannung $V_{REF1}$ arbeitet, zusätzlich auf 1 gesetzt. Auf diese Weise wird ein Fehler in der $V_{REF2}$-Referenz erkannt, indem $FLAG_{UV}$ und $FLAG_{OV}$ auf den Wert 1 gesetzt werden.

In Figur 4 ist eine Ausführungsform der erfindungsgemäßen Schaltung dargestellt, welche im Gegensatz zu Figur 3 nur einen Unterspannungserkennungs-Komparator COMPuv mit wechselbarer Referenz aufweist, um eine deutliche Unterscheidung zwischen Überspannung/Unterspannung aufgrund von Fehlern in den Reglern und Fehlern in den Referenzen zu ermöglichen. Der COMPuv benutzt die Referenz $V_{REF2}$, wenn das $FLAG_{OV}$ den Wert 0 hat und die Referenz $V_{REF1}$, wenn das $FLAG_{OV}$ den Wert 1 aufweist. Bei dieser Ausführungsform wird wegen eines Defekts in der Referenz $V_{REF2}$, wenn die Spannung $V_{DD\_PROT}$ deutlich niedriger als 2,75 Volt ist, der Wert für $FLAG_{UV}$ aufgrund des Wechselns auf die $V_{REF1}$-Referenz zusätzlich auf 1 gesetzt. Auf diese Weise wird ein Fehler in der $V_{REF2}$-Referenz erkannt, indem $FLAG_{UV}$ und $FLAG_{OV}$ auf den Wert 1 gesetzt werden. Analog dazu besteht eine Überspannung am $V_{DD\_PWR}$, wenn die Referenz $V_{REF1}$ wegen eines Defekts auf einen höheren Wert als 1,5 Volt abweicht. Der Schutzregler begrenzt die Spannung $V_{DD\_PROT}$ auf 3,4 Volt und damit Vuv auf 1,5 Volt. Wegen Überspannung setzt der COMPov das $FLAG_{OV}$ auf den Wert 1 und damit wechselt die Referenz für $COMP_{UV}$ von $V_{REF2}$ nach $V_{REF1}$. Der höhere Wert für die Spannung $V_{REF1}$ bewirkt jedoch, dass der Komparator COMPuv den Wert für FLAGuv auf 1 setzt, da der $V_{REF1}$-Wert höher als seine Schwellenspannung Vuv ist. Somit wird ein Defekt der $V_{REF1}$, welche ihren Zielwert um 0,285 Volt erhöht, durch ein Setzen von FLAGuv und FLAGov auf den Wert 1 angezeigt.

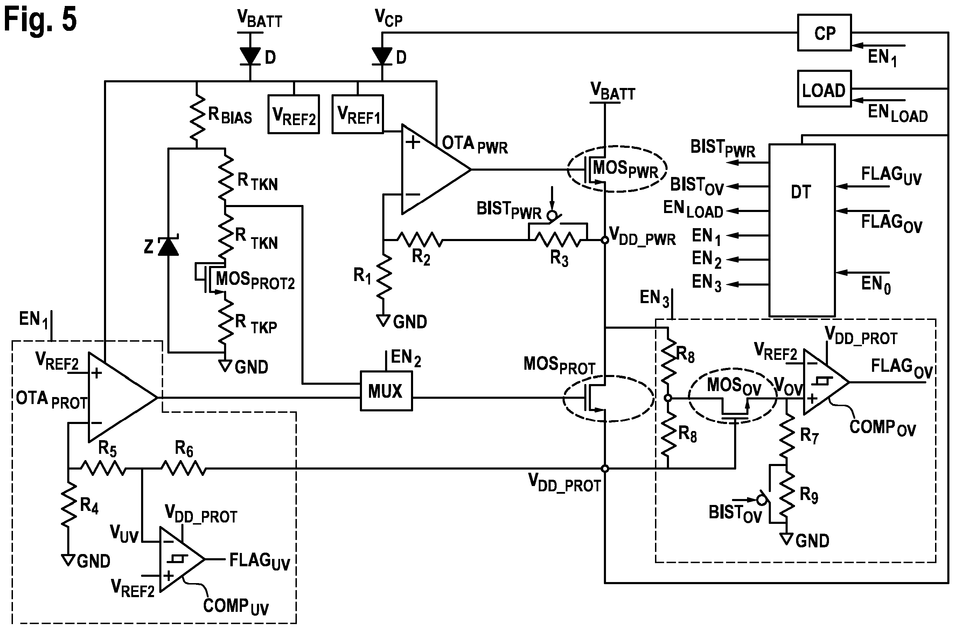

In der Figur 5 ist eine alternative Ausführungsform der erfindungsgemäßen Schaltung dargestellt, welche einen Abschaltmodus ermöglicht, bei dem der Überspannungserkennungs-Komparator COMPov mittels des binären Signals $EN_3$ und der Schutzregler mittels des binären Signals $EN_1$ ausgeschaltet werden können und der Schutztransistor $MOS_{PROT}$ über $EN_2$ passiv geregelt wird, sodass die Spannung die maximale Betriebsspannung von 3,6 Volt nicht übersteigt. Dies ist durch die Verwendung einer parallelen Kombination einer Zener-Klemmdiode Z und Widerständen $R_{TKP}$ mit einem positiven und $R_{TKN}$ mit einem negativen Temperaturkoeffizienten und einer Transistor-Schwellenspannung von $MOS_{PROT2}$ möglich. Die Gate-Steuerspannung für den Schutztransistor $MOS_{PROT2}$ wird aus dem aus den Widerständen $R_{TKP}$, $R_{TKN}$ gebildeten Widerstandsteiler und der Transistor-Schwellenspannung $MOS_{PROT2}$ erzeugt, sodass die Gate-Spannung einen Temperaturkoeffizienten ähnlich dem der Schwellenspannung des Schutztransistors MOS$_{PROT}$ zeigt. Dies führt zu einer passiven Gate-Klemmspannung, die über Temperaturen stabil ist, welche die Spannung V$_{DD\_PROT}$ auf ein Maximum von 3,6 Volt beschränken können. In dieser Ausführungsform können die Überspannungserfassungslogik und die Schutzregelschleife bei Empfang eines externen Freigabesignals EN$_0$ durch den Digitalteil DT freigegeben werden, welcher die komplette anwendungsspezifische integrierte Schaltung (Application Specific Integrated Circuit; ASIC) vom Abschaltmodus/Standbymodus zum aktiven Modus schaltet. Anstelle des hochohmigen Widerstandsteilers (R$_7$, R$_8$, R$_9$), kann alternativ ein Differenzspannungsdetektor über Drain und Source des Transistors MOS$_{PROT}$ vorgesehen sein, um den Spannungsabfall über dem Transistor MOS$_{PROT}$ zu erfassen. Das gleiche Prinzip kann auch für Regler mit anderen Transistortypen wie PMOS oder BJT angepasst werden.

**Patentansprüche**

1. Elektrische Schaltung zum Erkennen von Schaltungsdefekten und/oder zur Vermeidung von Überspannungen in Reglern, umfassend

    - eine Leistungsreglerschaltung, aufweisend einen ersten Transistor (MOS$_{PWR}$), eine einen ersten Operationsverstärker (OTA$_{PWR}$) sowie eine erste Referenzspannungsquelle (V$_{REF1}$) umfassende Regelschleife und Rückkopplungswiderstände (R$_1$, R$_2$, R$_3$), und
    - eine Überspannungsunterdrückungsschaltung, aufweisend einen zweiten eine Ausgangsspannung (V$_{DD\_PWR}$) der Leistungsreglerschaltung an seinem Drain-Anschluss empfangenden und eine geschützte Spannung (V$_{DD\_PROT}$) an seinem Source-Anschluss bereitstellenden Transistor (MOS$_{PROT}$), eine einen zweiten Operationsverstärker (OTA$_{PROT}$) sowie eine zweite Referenzspannungsquelle (V$_{REF2}$) umfassende Regelschleife und Rückkopplungswiderstände (R$_4$, R$_5$, R$_6$), wobei die Leistungsreglerschaltung zur Bereitstellung der Ausgangsspannung (V$_{DD\_PWR}$) für die Überspannungsunterdrückungsschaltung und die Überspannungsunterdrückungsschaltung zur Bereitstellung der geschützten Spannung (V$_{DD\_PROT}$) vorgesehen ist, **gekennzeichnet durch** einen ersten Komparator (COMP$_{OV}$) und einen dritten Transistor (MOSov), dessen Gate-Anschluss mit dem Source-Anschluss des zweiten Transistors (MOS$_{PROT}$) verbunden ist und welcher zur Begrenzung einer Überspannung am Source-Anschluss des dritten Transistors (MOSov) vorgesehen ist, wobei am Source-Anschluss des dritten Transistors (MOS$_{OV}$) ein Eingang des ersten Komparators (COMP$_{OV}$) angeschlossen ist, welcher zur Detektion der Überspannung durch Vergleich der begrenzten Spannung (Vov) mit einer Spannung der zweiten Referenzspannungsquelle (V$_{REF2}$) vorgesehen ist, wobei die Eingänge des zweiten Operationsverstärkers (OTA$_{PROT}$) die Rückkopplungsspannung und eine seitens der zweiten Referenzspannungsquelle (V$_{REF2}$) bereitgestellten Referenzspannung umfassen und sein Ausgang den Gate-Anschluss des zweiten Transistors (MOS$_{PROT}$) verbindet.

2. Elektrische Schaltung nach Anspruch 1, wobei der zur Detektion einer Überspannung vorgesehene erste Komparator (COMPov) zur Ausgabe eines eine Überspannung darstellenden binären Wertes (FLAGov) vorgesehen ist.

3. Elektrische Schaltung nach Anspruch 1 oder Anspruch 2, ferner umfassend eine Schaltung zur Detektion einer Unterspannung des Leistungsreglers mit einem die Spannung der zweiten Referenzspannungsquelle (V$_{REF2}$) mit einer über die bereitgestellte geschützte Spannung (V$_{DD\_PROT}$) erhaltenen Spannung (V$_{UV}$) vergleichenden zweiten Komparator (COMP$_{UV}$).

4. Elektrische Schaltung nach Anspruch 3, wobei der zur Detektion einer Unterspannung vorgesehene zweite Komparator (COMPuv) zur Ausgabe eines eine Unterspannung darstellenden binären Wertes (FLAGuv) vorgesehen ist.

5. Elektrische Schaltung nach einem Anspruch 1 oder 2, ferner umfassend eine Schaltung zur Detektion einer Unterspannung des Leistungsreglers mit zwei Komparatoren (COMP$_{UV1}$, COMP$_{UV2}$), wobei ein Vergleich der über die Spannung der ersten beziehungsweise zweiten Referenzspannungsquelle (V$_{REF1}$, V$_{REF2}$) erhaltenen Spannung mit einer von mittels der bereitgestellten geschützten Spannung (V$_{DD\_PROT}$) erhaltenen Spannung (Vuv) vorgesehen ist.

6. Elektrische Schaltung nach Anspruch 5, wobei die zwei Komparatoren (COMP$_{UV1}$, COMP$_{UV2}$) zur Ausgabe eines eine Unterspannung darstellenden binären Wertes (FLAGuvi, FLAG$_{UV2}$) vorgesehen sind.

7. Elektrische Schaltung nach Anspruch 6, wobei ein logisches Und-Gatter (AND) zur Verknüpfung der die eine Unterspannung reflektierenden binären Werte (FLAGuvi, FLAG$_{UV2}$) vorgesehen ist.

8. Elektrische Schaltung nach Anspruch 1 oder 2, ferner umfassend eine Schaltung zur Detektion eines eine Überspannung des Leistungsreglers oder eine Unterspannung des Schutzreglers verursachenden Defekts in den ersten und zweiten Referenzspannungsquellen , umfassend einen Unterspannungserkennungs-Komparator (COMPuv) mit wechselbarer Referenzquelle.

9. Elektrische Schaltung nach einem der Ansprüche 1 bis 8, ferner umfassend einen Digitalteil (DT), an welchen eine Bereitstellung der geschützten Spannung ($V_{DD\_PROT}$) vorgesehen ist.

10. Elektrische Schaltung nach Anspruch 9, wobei der Digitalteil (DT) Eingänge zum Empfang binärer Werte (FLAGov, FLAGuv) und Ausgänge zum Senden binärer Werte ($BIST_{PWR}$, BISTov, $EN_{LOAD}$, $EN_1$, $EN_2$, $EN_3$) aufweist.

11. Elektrische Schaltung nach einem der Ansprüche 1 bis 10, wobei diese zu einer Versorgung der ersten Referenzspannungsquelle ($V_{REF1}$), der zweiten Referenzspannungsquelle ($V_{REF2}$), der Leistungsreglerschaltung und der Überspannungsunterdrückungsschaltung mit einer externen Batteriespannung ($V_{BATT}$) verbindbar ist.

**Claims**

1. Electrical circuit for identifying circuit defects and/or for avoiding overvoltages in regulators, comprising

   - a power regulator circuit, having a first transistor ($MOS_{PWR}$), a control loop comprising a first operational amplifier ($OTA_{PWR}$) and a first reference voltage source ($V_{REF1}$), and feedback resistors (R1, R2, R3), and
   - an overvoltage suppression circuit, having a second transistor ($MOS_{PROT}$), which receives an output voltage ($V_{DD\_PWR}$) of the power regulator circuit at its drain connection and provides a protected voltage ($V_{DD\_PROT}$) to its source connection, a control loop comprising a second operational amplifier ($OTA_{PROT}$) and a second reference voltage source ($V_{REF2}$), and feedback resistors ($R_4$, $R_5$, $R_6$), wherein the power regulator circuit is provided in order to provide the output voltage ($V_{DD\_PWR}$) for the overvoltage suppression circuit and the overvoltage suppression circuit is provided in order to provide the protected voltage ($V_{DD\_PROT}$), **characterized by** a first comparator ($COMP_{OV}$) and a third transistor (MOSov), the gate connection of which is connected to the source connection of the second transistor ($MOS_{PROT}$), and which is provided to limit an overvoltage at the source connection of the third transistor ($MOS_{OV}$), wherein an input of the first comparator ($COMP_{OV}$) is connected to the source connection of the third transistor (MOSov), which comparator is provided to detect the overvoltage by comparing the limited voltage ($V_{OV}$) with a voltage of the second reference voltage source ($V_{REF2}$), wherein the inputs of the second operational amplifier ($OTA_{PROT}$) comprise the feedback voltage and a reference voltage provided by the second reference voltage source ($V_{REF2}$) and the output thereof connects the gate connection of the second transistor ($MOS_{PROT}$) .

2. Electrical circuit according to Claim 1, wherein provision is made for the first comparator ($COMP_{OV}$) that is provided to detect an overvoltage to output a binary value (FLAGov) that represents an overvoltage.

3. Electrical circuit according to Claim 1 or Claim 2, also comprising a circuit for detecting an undervoltage of the power regulator, comprising a second comparator ($COMP_{UV}$) that compares the voltage of the second reference voltage source ($V_{REF2}$) with a voltage ($V_{UV}$) obtained via the provided protected voltage ($V_{DD\_PROT}$).

4. Electrical circuit according to Claim 3, wherein provision is made for the second comparator ($COMP_{UV}$) that is provided to detect an undervoltage to output a binary value (FLAGuv) that represents an undervoltage.

5. Electrical circuit according to Claim 1 or 2, also comprising a circuit for detecting an undervoltage of the power regulator, comprising two comparators ($COMP_{UV1}$, $COMP_{UV2}$), wherein a comparison of the voltage obtained via the voltage of the first or the second reference voltage source ($V_{REF1}$, $V_{REF2}$) with a voltage ($V_{UV}$) obtained by means of the provided protected voltage ($V_{DD\_PROT}$) is provided.

6. Electrical circuit according to Claim 5, wherein the two comparators ($COMP_{UV1}$, $COMP_{UV2}$) are provided to output a binary value (FLAGuvi, $FLAG_{UV2}$) that represents an undervoltage.

7. Electrical circuit according to Claim 6, wherein a logic AND gate (AND) is provided to link the binary values (FLAGuvi, $FLAG_{UV2}$) that reflect an undervoltage.

8. Electrical circuit according to Claim 1 or 2, also comprising a circuit for detecting a defect, which causes an overvoltage of the power regulator or an undervoltage of the protective regulator, in the first and the second reference voltage source, comprising an undervoltage identification comparator ($COMP_{UV}$) with a changeable reference source.

9. Electrical circuit according to one of Claims 1 to 8, also comprising a digital part (DT) to which provision is made to provide the protected voltage ($V_{DD\_PROT}$).

10. Electrical circuit according to Claim 9, wherein the digital part (DT) has inputs for receiving binary values (FLAGov, FLAGuv) and outputs for sending binary values ($BIST_{PWR}$, $BIST_{OV}$, $EN_{LOAD}$, $EN_1$, $EN_2$, $EN_3$)

11. Electrical circuit according to one of Claims 1 to 10, wherein said circuit is able to be connected to an external battery voltage ($V_{BATT}$) in order to supply power to the first reference voltage source ($V_{REF1}$), the second reference voltage source ($V_{REF2}$), the power regulator circuit and the overvoltage suppression circuit.

**Revendications**

1. Circuit électrique destiné à la reconnaissance de défauts de circuit et/ou à la prévention de surtensions dans des régulateurs, comprenant

   - un circuit régulateur de puissance, possédant un premier transistor ($MOS_{PWR}$), une boucle de régulation comprenant un premier amplificateur opérationnel ($OTA_{PWR}$) ainsi qu'une première source de tension de référence ($V_{REF1}$) et des résistances de contre-réaction (R1, R2, R3), et
   - un circuit de suppression des surtensions, possédant un deuxième transistor ($MOS_{PROT}$) qui reçoit une tension de sortie ($V_{DD\_PWR}$) du circuit régulateur de puissance à sa borne de drain et qui fournit une tension protégée ($V_{DD\_PROT}$) à sa borne de source, une boucle de régulation comprenant un deuxième amplificateur opérationnel ($OTA_{PROT}$) ainsi qu'une deuxième source de tension de référence ($V_{REF2}$) et des résistances de contre-réaction ($R_4$, $R_5$, $R_6$), le circuit régulateur de puissance étant destiné à fournir la tension de sortie ($V_{DD\_PWR}$) pour le circuit de suppression des surtensions et le circuit de suppression des surtensions à fournir la tension protégée ($V_{DD\_PROT}$), **caractérisé par** un premier comparateur ($COMP_{OV}$) et un troisième transistor (MOSov), dont la borne de gâchette est reliée à la borne de source du deuxième transistor ($MOS_{PROT}$) et lequel est destiné à limiter une surtension au niveau de la borne de source du troisième transistor (MOSov), une entrée du premier comparateur ($COMP_{OV}$) étant raccordée à la borne de source du troisième transistor ($MOS_{OV}$), laquelle est destinée à détecter la surtension par comparaison de la tension limitée ($V_{OV}$) avec une tension de la deuxième source de tension de référence ($V_{REF2}$), les entrées du deuxième amplificateur opérationnel ($OTA_{PROT}$) comprenant la tension de contre-réaction et une tension de référence fournie du côté de la deuxième source de tension de référence ($V_{REF2}$) et sa sortie reliant la borne de gâchette du deuxième transistor ($MOS_{PROT}$) .

2. Circuit électrique selon la revendication 1, le premier comparateur ($COMP_{OV}$) destiné à détecter une surtension étant destiné à délivrer une valeur binaire (FLAGov) qui représente une surtension.

3. Circuit électrique selon la revendication 1 ou la revendication 2, comprenant en outre un circuit de détection destiné à détecter une sous-tension du régulateur de puissance avec un deuxième comparateur ($COMP_{UV}$) qui compare la tension de la deuxième source de référence ($V_{REF2}$) avec une tension ($V_{UV}$) obtenue par le biais de la tension protégée ($V_{DD\_PROT}$) fournie.

4. Circuit électrique selon la revendication 3, le deuxième comparateur ($COMP_{UV}$) destiné à détecter une sous-tension étant prévu pour délivrer une valeur binaire (FLAGuv) qui représente une sous-tension.

5. Circuit électrique selon l'une des revendications 1 ou 2, comprenant en outre un circuit destiné à détecter une sous-tension du régulateur de puissance avec deux comparateurs ($COMP_{UV1}$, $COMP_{UV2}$), une comparaison de la tension obtenue par le biais de la première ou de la deuxième source de tension de référence ($V_{REF1}$, $V_{REF2}$) avec une tension ($V_{UV}$) obtenue au moyen de la tension protégée ($V_{DD\_PROT}$) fournie étant prévue.

6. Circuit électrique selon la revendication 5, les deux comparateurs ($COMP_{UV1}$, $COMP_{UV2}$) étant destinés à délivrer en sortie une valeur binaire ($FLAG_{UV1}$, $FLAG_{UV2}$) qui représente une sous-tension.

7. Circuit électrique selon la revendication 6, une porte ET logique (AND) destinée à combiner les valeurs binaires (FLAG$_{UV1}$, FLAG$_{UV2}$) reflétant ladite sous-tension étant présente.

8. Circuit électrique selon la revendication 1 ou 2, comprenant en outre un circuit destiné à la détection d'un défaut dans les première et deuxième sources de tension de référence provoquant une surtension du régulateur de puissance ou une sous-tension du régulateur de protection, comprenant un comparateur de reconnaissance de sous-tension (COMP$_{UV}$) à source de référence interchangeable.

9. Circuit électrique selon l'une des revendications 1 à 8, comprenant en outre une partie numérique (DT) au niveau de laquelle est prévue une fourniture de la tension protégée (V$_{DD\_PROT}$).

10. Circuit électrique selon la revendication 9, la partie numérique (DT) possédant des entrées pour la réception de valeurs binaires (FLAGov, FLAGuv) et des sorties pour l'émission de valeurs binaires (BIST$_{PWR}$, BIST$_{OV}$, EN$_{LOAD}$, EN$_1$, EN$_2$, EN$_3$) .

11. Circuit électrique selon l'une des revendications 1 à 10, celui-ci pouvant être connecté à une tension de batterie externe (V$_{BATT}$) pour une alimentation de la première source de tension de référence (V$_{REF1}$), de la deuxième source de tension de référence (V$_{REF2}$), du circuit régulateur de puissance et du circuit de suppression des surtensions.

Fig. 1

Fig. 2

EP 3 740 836 B1

**Fig. 3**

EP 3 740 836 B1

Fig. 4

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7576964 B2
- US 9007737 B2
- US 20090033298 A1
- US 20120086419 A1